# EUROPEAN PATENT APPLICATION

(11) **EP 1 617 531 A1**
(43) Date of publication of application: **18.01.2006**
(21) Application number: 04729203.2
(22) Date of filing: 23.04.2004
(51) Int. Cl.: H01S 5/022

(54) **SEMICONDUCTOR LASER DEVICE**

(30) Priority: 24.04.2003 JP 2003120375
(71) Applicant: Tottori Sanyo Electric Co., Ltd., Tottori-shi, Tottori 680-8634 (JP)
(72) Inventor: WATANABE, M., Tottori Sanyo Electric Co., Ltd., Tottori-Shi, Tottori 680-8634 (JP); HONDA, Shoji, Tottori Sanyo Electric Co., LTD., Tottori-Shi, Tottori 680-8634 (JP); IWAMURA, Yasuhiro, Tottori Sanyo Electric Co., Ltd, Tottori-Shi, Tottori 680-8634 (JP); SHIMIZU, Gen, Tottori Sanyo Electric Co., LTD., Tottori-Shi, Tottori 680-8634 (JP); INOUE, Tetsuro, Tottori Sanyo Electric Co., Ltd., Tottori-Shi, Tottori 680-8634 (JP)
(74) Representative: Glawe, Delfs, Moll
(86) International application number: PCT/JP2004/005857
(87) International publication number: WO 2004/095663

(57) **Abstract**

A semiconductor laser device 1 has, arranged inside an airtight-sealed package 2, a semiconductor laser element 3 having an active region made of one material selected from the group consisting of an AlGaAs-based crystal, an AlGaInP-based crystal, an AlGaN-based crystal, and an InGaN-based crystal. The atmospheric gas inside the package 2 contains oxygen. The semiconductor laser element 3 has a dielectric oxide film formed on the laser emission surface thereof. The atmospheric gas is a mixture of oxygen and nitrogen, with an oxygen content of 20% or more.

## Description

### Technical field

The present invention relates to a semiconductor laser device.

### Background art

Conventionally widely used semiconductor laser diodes are short-wavelength semiconductor laser diodes and long-wavelength semiconductor laser diodes. In a short-wavelength semiconductor laser diode, the active layer, which forms the light-emitting region, is made of an AlGaAs-based (ternary-system) crystal or the like. In a long-wavelength semiconductor laser diode, the active layer is made of an InGaAsP-based (quaternary-system) crystal.

Such a semiconductor laser diode made of a ternary- or quaternary-system material is typically grown on a GaAs substrate. By varying the crystal composition ratio of each ingredient element, it is possible to produce light having a wavelength of 0.7 to 0.9 µm with an AlGaAs-based material and light having a wavelength of 1.1 to 1.7 µm with an InGaAsP-based material.

Such a semiconductor laser diode has a protective film (reflective film) fabricated on the facet thereof through which light is emitted, and is arranged inside a package filled with an atmospheric gas. This prevents the facet from being oxidized and thus from deteriorating.

The atmospheric gas, irrespective of whether used with a long-wavelength or short-wavelength semiconductor laser diode, typically is an inert gas such as nitrogen. Japanese Patent Application Published No. H4-6114 proposes using as the atmospheric gas a gas containing oxygen. According to this publication, using as the atmospheric gas a gas containing oxygen helps alleviate the deterioration of a long-wavelength semiconductor laser diode made of an InGaAsP-based (quaternary-system) crystal.

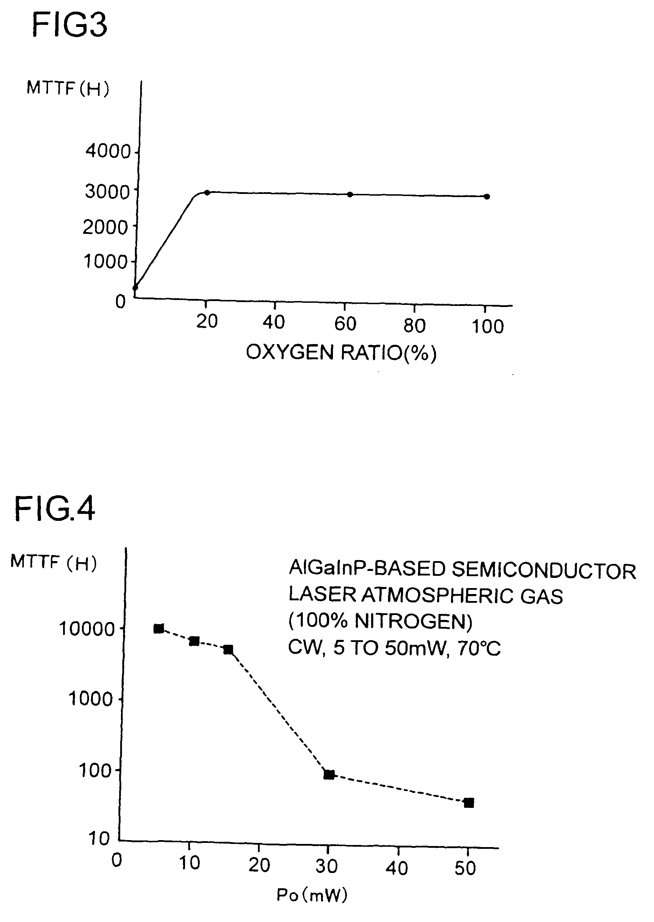

Conventionally, a short-wavelength semiconductor laser diode is used as a light source for reading data from a recording medium such as a CD or DVD, and is operated at an output power as low as about 5 mW, with nitrogen used as the atmospheric gas. Fig. 4 is a diagram showing how the MTTF (mean time to failure) varies with the output power of an AlGaInP-based short-wavelength semiconductor laser diode. The vertical axis represents the MTTF (in hours), and the horizontal axis represents the output power (in mW). The atmospheric temperature is 70°C.

As Fig. 4 shows, at a low output power under about 15 mW, the mean life time as represented by the MTTF is several thousand hours, ensuring satisfactory use. At a high output power of 30 mW or more required for recording data to a CD-R, DVD-R, or the like, however, in high-temperature operation, parts of the protective film and facet located near the light-emitting portion deteriorate. Disadvantageously, this greatly shortens the mean life time as represented by the MTTF.

### Disclosure of the invention

An object of the present invention is to provide, for a semiconductor laser element that is operated at a high output power for recording data to a CD-R, DVD-R, or the like, a structure that is less likely to deteriorate in high-temperature operation.

To achieve the above object, according to one aspect of the present invention, a semiconductor laser device is provided with a semiconductor laser element arranged inside an airtight-sealed package, the semiconductor laser element having an active region made of one material selected from the group consisting of an AlGaAs-based crystal, an AlGaInP-based crystal, an AlGaN-based crystal, and an InGaN-based crystal. In addition, the atmospheric gas inside the package contains oxygen.

The semiconductor laser element may have a dielectric oxide film formed on the laser emission surface thereof. It is preferable that the atmospheric gas be a mixture of oxygen and nitrogen, with an oxygen content of 20% or more. The semiconductor laser element emits light having a wavelength of, for example, 0.9 µm or less.

According to another aspect of the present invention, a semiconductor laser device is provided with a semiconductor laser element arranged inside an airtight-sealed package, the semiconductor laser element operating at a rated output power of 30 mW or more. In addition, the atmospheric gas inside the package contains oxygen.

According to still another aspect of the present invention, a semiconductor laser device is provided with a semiconductor laser element arranged inside an airtight-sealed package, the semiconductor laser element having an active region made of one material selected from the group consisting of an AIGaAs-based crystal, an AlGaInP-based crystal, an AlGaN-based crystal, and an InGaN-based crystal, the semiconductor laser element operating at a rated output power of 30 mW or more. In addition, the atmospheric gas inside the package contains oxygen.

### Brief description of drawings

Fig. 1 is a sectional view showing a semiconductor laser device embodying the invention.
Figs. 2A and 2B are characteristic diagrams showing how the operating current of the semiconductor laser device embodying the invention varies with time.
Fig. 3 is a characteristic diagram showing how the MTTF of the semiconductor laser device embodying the invention varies with the oxygen concentration.
Fig. 4 is a characteristic diagram showing how the MTTF of a conventional quaternary system semiconductor laser device varies with the rated output thereof.

### Best mode for carrying out the invention

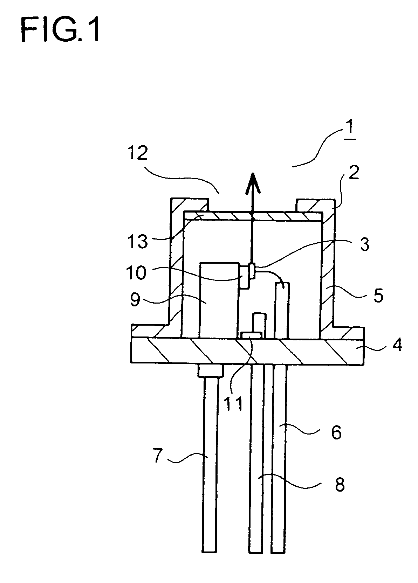

Hereinafter, an embodiment of the present invention will be described. Fig. 1 is a sectional view showing a semiconductor laser device embodying the invention. The semiconductor laser device 1 has a semiconductor laser element 3 arranged inside an airtight-sealed package 2.

The package 2 is made airtight by fixing a cap 5 to a stem 4 so as to leave an airtight interior space. The stem 4 is made of a metal, and is provided with a pair of lead pins 6 and 7 for power supply and a lead pin 8 for signal extraction. On the top surface of the stem 4, a heat-dissipating block 9 made of a metal is fixed. On a side surface of the heat-dissipating block 9, the semiconductor laser element 3 is fitted, with a submount 10 placed in between. The semiconductor laser element 3 may be fitted directly to the heat-dissipating block 9.

On the top surface of the stem 4, a photodetective element 11 is also arranged for monitoring the signal of the semiconductor laser element 3. In a case where the semiconductor laser device 1 is used solely for recording data to a CD-R, DVD-R, or the like, the photodetective element 11 may be omitted.

One electrode of the semiconductor laser element 3 is electrically connected to one 6 of the power-supply lead pins. The other electrode of the semiconductor laser element 3 is electrically connected to the other 7 of the power-supply lead pins. One electrode of the photodetective element 11 is electrically connected to the signal-extraction lead pin 8. The other electrode of the photodetective element 11 is electrically connected to the stem 4. One 6 of the power-supply lead pins and the signal-extraction lead pin 8 are electrically insulated from the stem 4. The other lead pin 7 is electrically connected to the stem 4.

In the top surface of the cap 5, a window 12 is formed through which the light from the semiconductor laser element 3 is extracted. The window 12 is covered with a glass plate 13.

The semiconductor laser element 3 is built as a semiconductor element of which the active region is made of a quaternary-system, AlGaInP-based crystal. The semiconductor laser element 3 may have one of various structures including the single hetero and double hetero structures. On the facet through which the semiconductor laser element 3 emits light, a protective film is fabricated that serves to prevent the deterioration of the facet and that also serves as a reflective film. The protective film is formed as a coating of an oxide dielectric such as alumina (Al₂O₃) or of any other appropriate material.

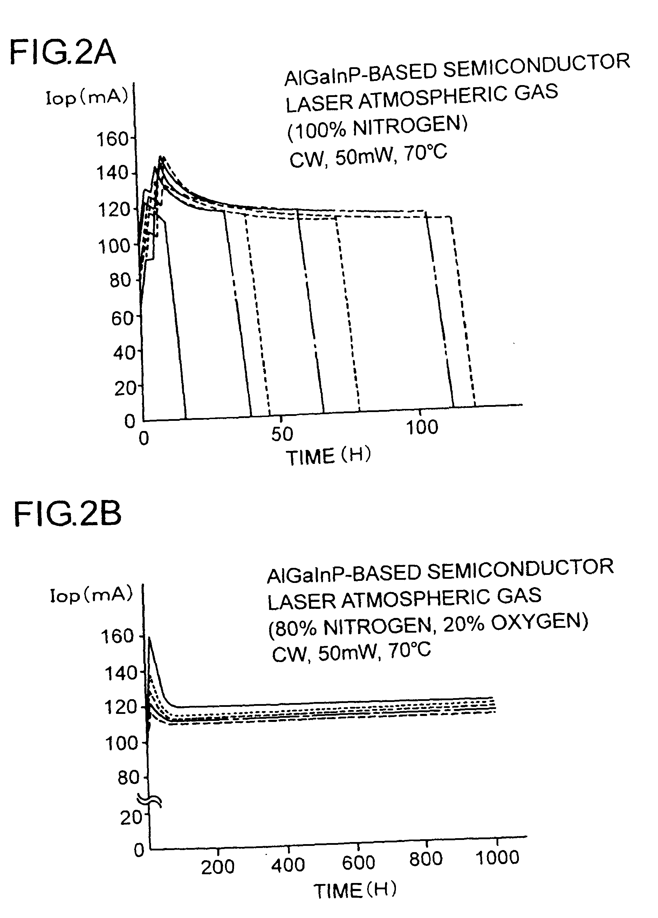

The interior of the package 2 is filled with, as an atmospheric gas, a gas containing oxygen. Figs. 2A and 2B show how the operating current (Iop) of the semiconductor laser element 3 varies with the lasing time. The vertical axis represents the operating current (in mA), and the horizontal axis represents the lapse of time (in hours).

Fig. 2A shows a case where the atmospheric gas was 100% nitrogen. Fig. 2B shows a case where the atmospheric gas was 80% nitrogen and 20% oxygen. Both Figs. 2A and 2B show the characteristics observed under the following same conditions: continuous lasing operation at an output power of 50 mW, at an ambient temperature of 70°C.

In the case shown in Fig. 2A, where the atmospheric gas was 100% nitrogen, all of the several samples tested became inoperative within 150 hours (with a MTTF of 100 hours or less). By contrast, in the case shown in Fig. 2B, where the atmospheric gas was 80% nitrogen and 20% oxygen, all of the several samples tested continued to operate normally for 1,000 hours or more.

Fig. 3 shows how the characteristics, as represented by the MTTF, of the semiconductor laser element 3 vary with the mix ratio of oxygen in a mixture of oxygen and nitrogen used as the atmospheric gas sealed inside the package 2. The vertical axis represents the MTTF (in hours), and the horizontal axis represents the mix ratio (%) of oxygen.

As will be clear from Fig. 3, mixing oxygen helps greatly improve the MTTF. Here, the semiconductor laser element 3 was kept under the same conditions as in Fig. 2, specifically in continuous lasing operation at an output power of 50 mW, at an ambient temperature of 70°C.

The MTTF increases while the oxygen concentration increases from 0% to 20%, and thereafter remains largely unchanged at about 3,000 hours regardless of a further increase in the oxygen concentration. Hence, it is preferable that the atmospheric gas used with a semiconductor laser element operated at a high temperature and at a high output power contain 5% or more of oxygen. This results in a MTTF of 1,000 hour or more. It is more preferable that the atmospheric gas contain 10% or more of oxygen. This results in a MTTF of 2,000 hour or more. It is particularly preferable that the atmospheric gas contain 20% or more of oxygen. This results in a MTTF of 3,000 hour or more.

The embodiment described above deals with a case where the semiconductor laser element 3 is a semiconductor element having an active region made of an AlGaInP-based crystal. Also with other semiconductor elements of which the active region is made of an AlGaAs-based crystal, an AlGaN-based crystal, or an InGaN-based crystal (gallium-nitride-based crystal) and that emit short-wavelength light (having wavelengths of 0.9 µm or less), it was confirmed that characteristics similar to those shown in Figs. 2B and 3 were obtained.

Specifically, it was confirmed that arranging the semiconductor laser element 3 in an atmospheric gas containing oxygen, as compared with arranging it in an atmospheric gas containing no oxygen, helped alleviate the deterioration of the element, and permitted the element to operate stably for a long period.

It was found that, when a semiconductor laser element 3 was arranged in an atmospheric gas containing oxygen, a greater deterioration alleviating effect was obtained when the semiconductor laser element 3 was of a high-output type operating at a high rated output power than when it was of a low-output type operating at a low rated output power. For example, with a low-output type operating at a rated output power of 15 mW or less, increasing the oxygen concentration resulted in only a slight deterioration alleviating effect. By contrast, with a high-output type operating at a rated output power of 30 mW or more, mixing oxygen in the atmospheric gas resulted in a high deterioration alleviating effect, improving the MTTF from about 100 hours to 1,000 hour or more.

Thus, when a semiconductor laser element 3 is arranged in an atmospheric gas containing oxygen, it is possible to effectively alleviate the deterioration of the semiconductor laser element when it is of a high-output type that operates at a rated output power of 30 mW or more (or, in terms of pulse lasing output, 50 mW or more) and that thus can be used for recording than when it is of a low-output type for reading.

The atmospheric gas sealed inside the package 2 may be any gas other than a mixture of nitrogen and oxygen. It may be, for example, a mixture of an inert gas with oxygen, or a mixture of any other gas with oxygen. The atmospheric gas sealed inside the package 2 may be dry air.

### Industrial applicability

As described above, in a semiconductor laser device, in particular in a short-wavelength, high-output-type semiconductor laser device, using a gas containing oxygen as the atmospheric gas that fills the interior of the package helps alleviate the deterioration of the semiconductor laser element, and thus permits the semiconductor laser element to operate stably for a long period.

## Claims

1. A semiconductor laser device comprising a semiconductor laser element arranged inside an airtight-sealed package, the semiconductor laser element having an active region made of one material selected from the group consisting of an AlGaAs-based crystal, an AlGaInP-based crystal, an AlGaN-based crystal, and an InGaN-based crystal,
wherein an atmospheric gas inside the package contains oxygen.

2. The semiconductor laser device of claim 1,
wherein the semiconductor laser element has a dielectric oxide film formed on a laser emission surface thereof.

3. The semiconductor laser device of claim 1,
wherein the atmospheric gas is a mixture of oxygen and nitrogen, with an oxygen content of 20% or more.

4. The semiconductor laser device of claim 1,
wherein the semiconductor laser element emits light having a wavelength of 0.9 µm or less.

5. A semiconductor laser device comprising a semiconductor laser element arranged inside an airtight-sealed package, the semiconductor laser element operating at a rated output power of 30 mW or more,
wherein an atmospheric gas inside the package contains oxygen.

6. The semiconductor laser device of claim 5,
wherein the atmospheric gas is a mixture of oxygen and nitrogen, with an oxygen content of 20% or more.

7. A semiconductor laser device comprising a semiconductor laser element arranged inside an airtight-sealed package, the semiconductor laser element having an active region made of one material selected from the group consisting of an AlGaAs-based crystal, an AlGaInP-based crystal, an AlGaN-based crystal, and an InGaN-based crystal, the semiconductor laser element operating at a rated output power of 30 mW or more,
wherein an atmospheric gas inside the package contains oxygen.

8. The semiconductor laser device of claim 7,
wherein the atmospheric gas is a mixture of oxygen and nitrogen, with an oxygen content of 20% or more.
